(19) Europäisches Patentamt / European Patent Office / Office européen des brevets

(11) **EP 2 368 273 B1**

(12) **FASCICULE DE BREVET EUROPEEN**

(45) Date de publication et mention de la délivrance du brevet:
**13.07.2016 Bulletin 2016/28**

(21) Numéro de dépôt: **09803862.3**

(22) Date de dépôt: **14.12.2009**

(51) Int Cl.:
*H01L 31/0224* *(2006.01)*

(86) Numéro de dépôt international:
**PCT/FR2009/052526**

(87) Numéro de publication internationale:
**WO 2010/072942 (01.07.2010 Gazette 2010/26)**

(54) **PHOTODETECTEUR COMPRENANT UNE REGION SEMICONDUCTRICE TRES MINCE**

PHOTODETEKTOR MIT SEHR DÜNNER HALBLEITENDER REGION

PHOTODETECTOR HAVING A VERY THIN SEMICONDUCTING REGION

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **24.12.2008 FR 0859077**

(43) Date de publication de la demande:
**28.09.2011 Bulletin 2011/39**

(73) Titulaire: **Commissariat à l'Énergie Atomique et aux Énergies Alternatives
75015 Paris (FR)**

(72) Inventeurs:
• **LE PERCHEC, Jérôme**
  **F-38000 Grenoble (FR)**
• **DESIERES, Yohan**
  **F-38250 Lans En Vercors (FR)**

(74) Mandataire: **Thibon, Laurent et al
Cabinet Beaumont
1, rue Champollion
38000 Grenoble (FR)**

(56) Documents cités:
**EP-A- 1 995 793        WO-A-2008/072688
JP-A- 2007 273 832      US-A1- 2006 151 807
US-A1- 2008 090 318**

• **"High-efficiency and high-speed silicon metal-semiconductor-metal photodetectors operating in the infrared" APPLIED PHYSICS LETTERS, AIP, AMERICAN INSTITUTE OF PHYSICS, MELVILLE, NY, US, vol. 70, no. 6, 10 février 1997 (1997-02-10), pages 753-755, XP012018324 ISSN: 0003-6951**

**Description**

Domaine de l'invention

La présente invention concerne un photodétecteur. La présente invention concerne un tel photodétecteur comprenant une couche semiconductrice d'une épaisseur nettement inférieure à la longueur d'onde de la lumière que l'on souhaite détecter.

Exposé de l'art antérieur

Les photodétecteurs actuels comprennent généralement une couche semiconductrice associée à un dispositif de transfert de charges. Lorsqu'un faisceau lumineux éclaire la couche semiconductrice, les photons incidents forment des paires électrons/trous dans celle-ci. Ces porteurs sont ensuite transférés par le dispositif de transfert de charges vers un circuit électronique qui permet leur quantification.

La profondeur moyenne de formation des paires électrons/trous dans une couche semiconductrice dépend de la longueur d'onde du faisceau lumineux incident et du matériau semiconducteur utilisé : plus la longueur d'onde est élevée, plus les paires électrons/trous sont susceptibles de se former profondément dans une couche semiconductrice. Par exemple, pour absorber environ 99 % de lumière rouge, il est nécessaire d'avoir une couche de silicium d'une épaisseur d'environ 10 $\mu$m. Pour de la lumière bleue, une couche de silicium ayant une épaisseur de l'ordre de 3 $\mu$m suffit à atteindre un tel taux d'absorption. On note que ces épaisseurs sont très supérieures aux longueurs d'onde des ondes lumineuses que l'on détecte.

On cherche généralement à réduire la taille des pixels d'un photodétecteur. La réduction de la surface occupée par chaque pixel sur la couche semiconductrice pose notamment des problèmes d'isolation des régions photosensibles entre elles. En effet, pour éviter les interférences entre pixels voisins, on prévoit généralement de former des tranchées isolantes autour de chacun d'eux. Si la couche semiconductrice est relativement épaisse, les tranchées isolantes occupent une surface non négligeable de la couche semiconductrice, ce qui n'est pas compatible avec la diminution de la taille globale des pixels. On est donc amené à réduire l'épaisseur des couches semiconductrices. Cependant, comme on l'a indiqué précédemment, la formation de couches actives très minces ne permet pas une absorption et une détection de toute la lumière incidente.

On a donc proposé d'augmenter l'épaisseur équivalente de la couche semiconductrice en faisant passer les photons deux ou plusieurs fois dans cette couche. Ainsi, on peut prévoir un miroir d'un côté de la couche semiconductrice pour assurer un double passage dans celle-ci. On peut également prévoir, de part et d'autre de la couche semiconductrice, des éléments réfléchissants pour former des structures de type Fabry-Pérot. En pratique, ces éléments réfléchissants sont des miroirs de Bragg qui sont généralement épais, constitués par exemple d'un empilement de 10 à 30 couches quart d'onde. On perd donc l'avantage de la réduction d'épaisseur de la couche semiconductrice active.

De tels dispositifs sont notamment décrits dans la demande de brevet US 2006/151807 où une résonance est créée entre un miroir inférieur (miroir de Bragg ou métallique) et un réseau métallique supérieur formant miroir. Dans un tel dispositif, l'épaisseur de la cavité entre les miroirs inférieurs et supérieurs doit être un multiple du quart du rapport entre la longueur d'onde incidente et l'indice optique moyen entre miroir supérieur et inférieur. Ainsi, il n'est pas possible de réduire l'épaisseur de cette cavité en dessous d'une certaine valeur.

On a alors proposé d'utiliser un autre effet pour diminuer l'épaisseur des couches semiconductrices de photodétection. Cet effet consiste à tirer profit de phénomènes physiques d'oscillation groupée d'électrons (résonances plasmons).

Le document US2008/0090318 décrit un photodétecteur à resonances plasmons.

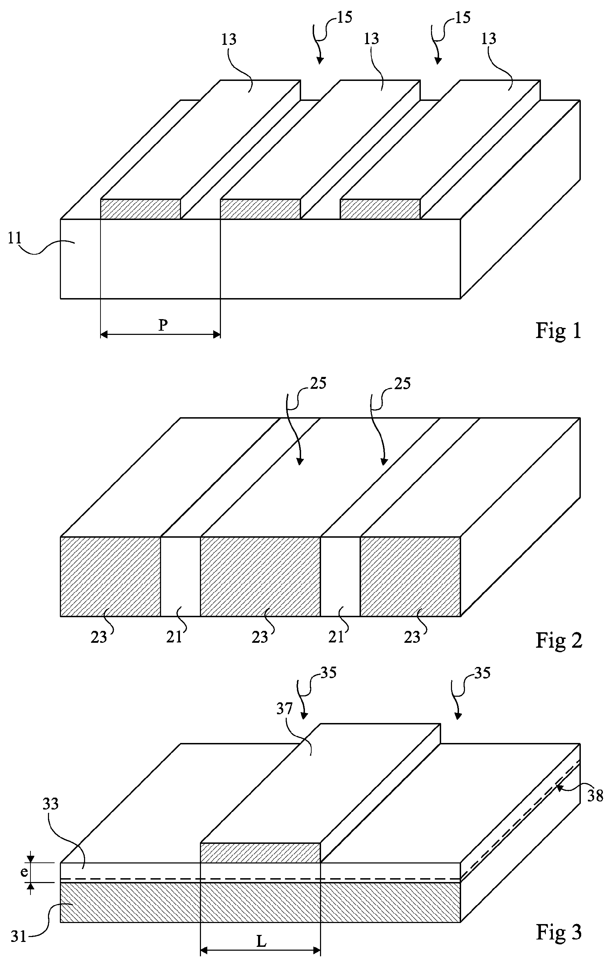

En figure 1, sur un substrat semiconducteur 11 s'étendent de nombreuses bandes métalliques 13 formant, en surface du substrat 11, un réseau périodique. Le photodétecteur de la figure 1 est éclairé par un faisceau lumineux représenté par des flèches 15. Lorsque la période P du réseau constitué des bandes 13 est égale au rapport entre la longueur d'onde du faisceau lumineux 15 et l'indice optique du matériau semiconducteur 11, il apparaît, aux interfaces métal-semiconducteur, des résonances plasmons de surface. Ces résonances permettent le confinement des photons, et donc de la zone de formation des paires électrons/trous, dans le substrat 11, au voisinage des bandes métalliques 13.

Cependant, une structure telle que celle de la figure 1 a l'inconvénient d'être très sélective en fréquence. De plus, l'efficacité d'une telle structure dépend fortement de l'angle d'incidence et de la polarisation du faisceau lumineux 15. Enfin, la période P doit être de l'ordre du rapport entre la longueur d'onde du faisceau lumineux 15 et l'indice optique du matériau semiconducteur 11, ce qui ne permet pas d'envisager des détecteurs élémentaires plus petits.

La figure 2 illustre un autre photodétecteur comprenant des régions semiconductrices très minces 21 qui s'étendent verticalement entre des régions métalliques 23. Le photodétecteur est éclairé par un faisceau lumineux 25. Dans ce photodétecteur métallique à cavités semiconductrices verticales apparaissent des résonances plasmons de surface couplées entre deux interfaces semiconducteur/métal en regard. Cependant, pour que les résonances plasmons de surface couplées se forment entre deux interfaces semiconducteur/métal en regard, les cavités semiconductrices 21 doivent être très étroites, d'une épaisseur très inférieure à la longueur d'onde de la lumière considérée. Un problème se pose alors pour la fabrication de cette structure.

Ainsi, il existe un besoin d'un photodétecteur moins sélectif en fréquence que les photodétecteurs à résonances plasmons connus, moins dépendant de la polarisation et de l'angle d'incidence du faisceau lumineux à détecter et dont la taille peut être largement inférieure à la longueur d'onde du faisceau lumineux incident.

Par ailleurs, il est souhaitable de pouvoir réaliser des photodétecteurs dans lesquels le matériau semiconducteur puisse être choisi parmi une large gamme de composés semiconducteurs dont certains ne peuvent être déposés qu'en couche extrêmement mince.

Résumé

Un objet d'un mode de réalisation de la présente invention est de prévoir un photodétecteur comprenant une couche semiconductrice très mince et présentant au moins l'une des caractéristiques suivantes :

- être moins sélectif en fréquence que les dispositifs à résonances plasmons connus, c'est-à-dire que le spectre d'absorption présente une largeur à mi-hauteur de l'ordre du tiers de la longueur d'onde à détecter ;
- être peu sensible à l'angle d'incidence du faisceau lumineux incident ;
- être peu sensible à la polarisation du faisceau lumineux incident ;
- être capable de sélectionner l'une des deux polarisations fondamentales ; et
- avoir des dimensions inférieures à la longueur d'onde d'un faisceau lumineux à détecter.

Ainsi, un mode de réalisation de la présente invention prévoit un photodétecteur comme décrit dans la revendication 1.

Selon un mode de réalisation de la présente invention, au moins une dimension du plot, dans un plan parallèle à la couche semiconductrice, est inférieure au rapport entre la longueur d'onde du faisceau lumineux et le double de l'indice optique de la couche semiconductrice.

Selon un mode de réalisation de la présente invention, la portion de la couche semiconductrice comporte une jonction PN ou PIN horizontale ou verticale.

Selon un mode de réalisation de la présente invention, une couche de matériau transparent recouvre le photodétecteur.

Selon un mode de réalisation de la présente invention, le photodétecteur comprend en outre une couche d'accrochage et/ou à gradient d'indice à l'interface entre la couche réfléchissante et la couche semiconductrice.

Selon un mode de réalisation de la présente invention, le ou les plots et la couche réfléchissante sont en un métal adapté à créer, lorsque la couche semiconductrice est éclairée, un mode plasmon de cavité dans cette couche semiconductrice.

Selon un mode de réalisation de la présente invention, la couche réfléchissante est en un métal dont l'épaisseur est supérieure à l'épaisseur de peau de ce métal, pour la longueur d'onde dudit faisceau lumineux.

Selon un mode de réalisation de la présente invention, le ou les plots métalliques ont une épaisseur comprise entre une fois et trois fois l'épaisseur de peau du métal les constituant, pour la longueur d'onde dudit faisceau lumineux.

Selon un mode de réalisation de la présente invention, le ou les plots et la couche réfléchissante sont en un matériau ayant une permittivité négative, par exemple un cristal ionique, destiné à former, lorsque la couche semiconductrice est éclairée, des phonons à l'interface entre ledit matériau et la couche semiconductrice.

Un autre mode de réalisation de la présente invention prévoit un capteur d'images multi-spectral comprenant plusieurs photodétecteurs élémentaires tels que décrit ci-dessus, les dimensions du ou des plots de chaque photodétecteur élémentaire étant adaptées au spectre à détecter.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

les figures 1 et 2, précédemment décrites, illustrent deux photodétecteurs à résonances plasmons connus permettant l'absorption de faisceaux lumineux dans des couches semiconductrices minces ;
la figure 3 illustre un photodétecteur à résonances plasmons selon un mode de réalisation de la présente invention ;
les figures 4, 5 et 6 illustrent des variantes d'un photodétecteur selon un mode de réalisation de la présente invention ;
les figures 7A et 7B sont des courbes illustrant des avantages d'un photodétecteur selon un mode de réalisation de la présente invention ;

les figures 8A, 8B et 8C illustrent trois formes possibles des plots supérieurs d'un photodétecteur selon un mode de réalisation de la présente invention ; et
la figure 9 illustre une variante d'un photodétecteur selon un mode de réalisation de la présente invention.

Par souci de clarté, de mêmes éléments ont été désignés par de mêmes références aux différentes figures et, de plus, comme cela est habituel dans la représentation de dispositifs semiconducteurs, les diverses figures ne sont pas tracées à l'échelle.

Description détaillée

Les inventeurs proposent un photodétecteur comportant une couche semiconductrice très mince dont l'absorption est améliorée. Pour cela, ils proposent une structure de type métal-semiconducteur-métal verticale qui a de plus l'avantage d'être peu sensible à l'angle d'incidence et à la fréquence optique du faisceau lumineux incident, comme nous le verrons par la suite. Cette structure peut également être configurée de façon à être peu dépendante de la polarisation du faisceau lumineux incident ou à sélectionner l'une des deux polarisations fondamentales du faisceau lumineux incident.

Dans ce qui précède et dans la description qui suit, on parle de la création de résonances plasmons de surface ou de modes plasmons à l'interface entre un métal et un matériau semiconducteur. On notera que l'on pourra également prévoir des structures similaires à celles présentées ici dans lesquelles les régions métalliques sont remplacées par des régions en un matériau ayant une permittivité négative dans le domaine spectral que l'on considère. De tels matériaux sont par exemple des matériaux semiconducteurs très fortement dopés ou encore des cristaux ioniques tel que le carbure de silicium. La formation de régions en l'un de ces matériaux plutôt qu'en un métal permet la formation, non pas de résonances plasmons de surface, mais de résonances phonons de surface. On notera que ces deux résonances provoquent des effets similaires sur les photons lumineux incidents.

La figure 3 illustre un mode de réalisation d'un photodétecteur à résonances plasmons.

Sur une couche métallique 31 est formée une couche en un matériau semiconducteur 33 ayant une épaisseur e strictement inférieure au quart du rapport entre la longueur d'onde d'un faisceau lumineux éclairant le dispositif (flèches 35) et l'indice optique de la couche semiconductrice 33. On notera que la couche semiconductrice 33 aura de préférence une épaisseur de l'ordre du dixième de ce rapport. La couche semiconductrice 33 est par exemple en silicium, en germanium, en un composé III-V ou encore en un matériau à faible bande interdite tel que l'InSb ou les composés de type CdHgTe. L'utilisation de l'un ou l'autre de ces matériaux pour former la couche semiconductrice 33 dépend de la longueur d'onde du faisceau lumineux que l'on souhaite détecter. En effet, ces différents matériaux permettent de couvrir une gamme de longueurs d'onde allant du proche ultraviolet (400 nm) à l'infrarouge (15 $\mu$m).

Sur la couche semiconductrice 33 est formé un plot métallique 37, en regard de la couche métallique 31. Ainsi, la couche semiconductrice 33, prise en sandwich entre la couche métallique 31 et le plot 37, définit une cavité optique. Le photodétecteur est éclairé par la face comprenant la couche semiconductrice 33 et le plot métallique 37, comme cela est représenté en figure 3 par les flèches 35. La couche métallique 31 a de préférence une épaisseur supérieure à l'épaisseur de peau du métal la constituant à la fréquence du faisceau lumineux 35, l'épaisseur de peau du métal étant l'épaisseur au dessus de laquelle un champ lumineux ne se propage plus dans le métal. Le plot métallique 37 a de préférence une épaisseur comprise entre une fois et trois fois l'épaisseur de peau du métal qui le constitue à cette même fréquence. A titre d'exemple, le métal du plot 37 et de la couche 31 pourra être de l'or, de l'argent, de l'aluminium ou encore un alliage de ces matériaux ayant des propriétés optiques similaires. Dans l'exemple représenté, le plot 37 a une forme rectangulaire en vue de dessus.

La structure de la figure 3 permet d'utiliser la résonance électromagnétique apparaissant au sein du sandwich métal-semiconducteur-métal pour renforcer l'absorption de la couche semiconductrice 33, la couche métallique 31 et le plot métallique 37 formant un résonateur plasmonique de type cavité horizontale (les plasmons de cavité se forment entre le plot 37 et la couche 31). Les résonances plasmons de cavité permettent, de façon connue, le confinement des photons incidents dans la couche semiconductrice 33, entre le plot métallique 37 et la couche métallique 31. Pour que le photodétecteur fonctionne correctement et que les modes plasmons de cavité se forment, la largeur L du plot 37 doit être telle que :

$$L \approx \frac{\lambda}{2.n_{eff}} - \Delta(\lambda) , \qquad\qquad (\text{Équation 1})$$

$n_{eff}$ étant l'indice optique effectif du mode plasmon, supérieur à l'indice optique de la couche semiconductrice 33, $\Delta(\lambda)$ étant un terme positif qui traduit le décalage spectral lié à des déphasages ou à des absorptions dans le photodétecteur.

Plus simplement, la largeur du plot 37 doit être telle que :

$$L < \frac{\lambda}{2.n_{eff}} \, . \qquad\qquad \text{(Équation 2)}$$

Comme nous le verrons par la suite, un photodétecteur tel que celui de la figure 3, dont les dimensions répondent à l'équation (1) ou (2) et dont la cavité optique entre la couche métallique 31 et le plot métallique 37 (couche semiconductrice 33) a une épaisseur inférieure au quart du rapport entre la longueur d'onde du faisceau lumineux 35 et l'indice optique de la couche semiconductrice 33, a l'avantage de présenter une absorption significative, même si la longueur d'onde du faisceau lumineux varie légèrement.

Une couche d'accrochage 38, délimitée en figure 3 par des pointillés, peut être prévue entre la couche métallique 31 et la couche semiconductrice 33 pour permettre une bonne accroche entre ces deux couches. La couche 38 peut également être une fine couche à gradient d'indice ou de passivation, évitant des recombinaisons parasites de photoporteurs aux interfaces métalliques. On notera que, dans les variantes de réalisation suivantes, cette couche, bien que non représentée ni décrite, pourra être présente.

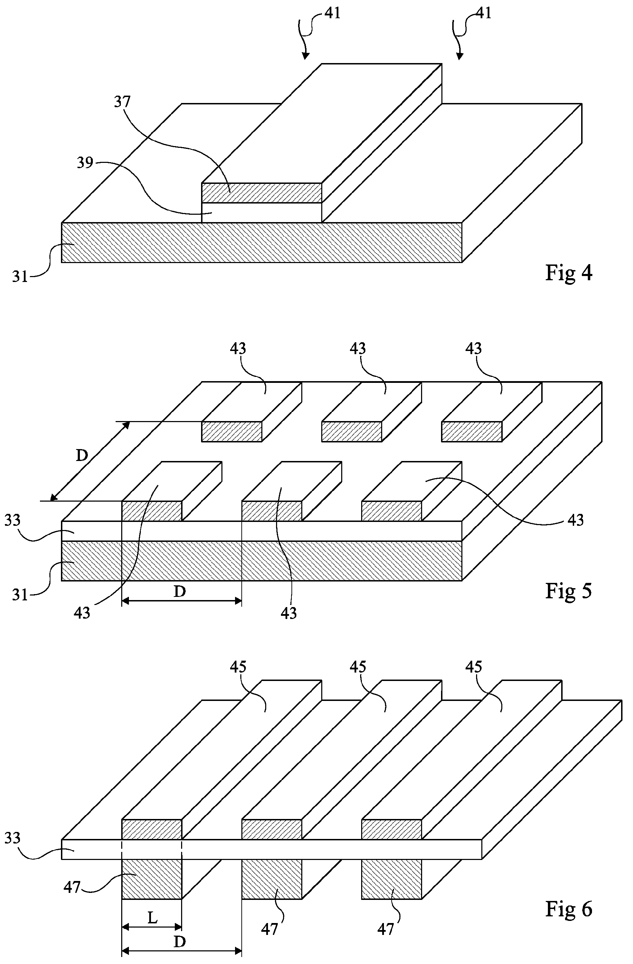

La figure 4 illustre une variante du photodétecteur de la figure 3. Sur une couche métallique 31 est formé un plot de matériau semiconducteur 39 recouvert d'un plot métallique 37. Comme dans le cas de la structure de la figure 3, des modes plasmons de surface se forment dans le plot semiconducteur 39, à l'interface entre le plot métallique 37 et le plot semiconducteur et à l'interface entre la couche métallique 31 et le plot semiconducteur 39, lorsque le photodétecteur est éclairé par un faisceau lumineux 41 de longueur d'onde adaptée. La formation des modes plasmons permet une meilleure absorption dans le plot semiconducteur 39. Les modes plasmons dans le plot semiconducteur 39 apparaissent lorsque la largeur du plot métallique 37 et la longueur d'onde du faisceau lumineux satisfont à l'équation (1) ou (2).

La figure 5 illustre une variante de photodétecteur dans laquelle plusieurs plots sont formés en surface d'une même couche semiconductrice. Sur une couche métallique 31 est formée une couche semiconductrice mince 33. Sur la couche semiconductrice 33 sont formés de nombreux plots métalliques 43. Dans l'exemple représenté, les plots 43 sont, en vue de dessus, carrés et sont formés périodiquement en surface de la couche semiconductrice 33. Chaque dimension des plots métalliques 43 en surface de la couche semiconductrice 33 respecte l'équation (1) ou (2). La périodisation des plots 43 permet de former des photodétecteurs plus grands.

Dans le cas d'une distribution périodique des plots 43 en surface de la couche de silicium 33, la période D du réseau doit être telle que :

$$D < \frac{3}{4}\frac{\lambda}{n} \, , \qquad\qquad \text{(Équation 3)}$$

pour que l'absorption de la couche semiconductrice 33 soit améliorée.

La figure 6 illustre une variante d'un photodétecteur comprenant une couche semiconductrice mince 33 en surface de laquelle est formé un réseau de plots rectangulaires 45 dont au moins la largeur L répond à l'équation (1) ou (2). La période D des plots 45, en surface de la couche 33 répond à l'équation (3). Sur la face inférieure de la couche semiconductrice 33 est formé un réseau de bandes 47 qui sont situées au moins en regard des plots 45. Des modes plasmons apparaissent ainsi aux interfaces semiconducteur/métal.

On notera que la formation de plots 45 rectangulaires favorise l'absorption d'un faisceau lumineux polarisé perpendiculairement à la direction principale des bandes 45 (polarisation TM). La formation de plots carrés tels que les plots 43 de la figure 5 permet d'avoir un photodétecteur peu dépendant de la polarisation du faisceau lumineux incident. On peut ainsi former un photodétecteur destiné à sélectionner l'une ou l'autre des polarisations fondamentales TE ou TM.

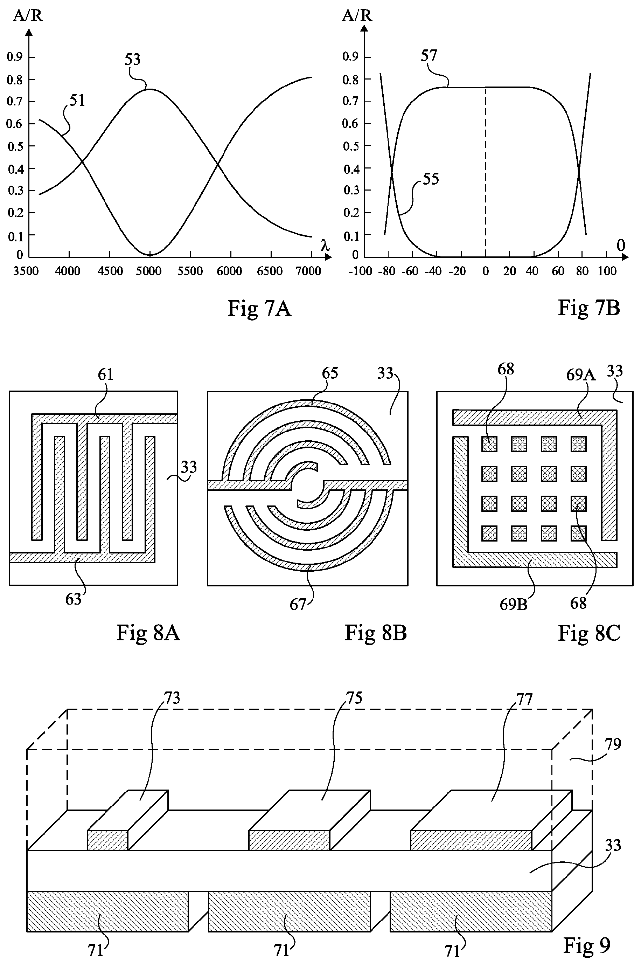

Les figures 7A et 7B sont des courbes illustrant des avantages des photodétecteurs présentés ici.

En figure 7A sont représentées, en fonction de la longueur d'onde d'un faisceau incident, deux courbes 51 et 53, respectivement du pouvoir réflecteur R d'un photodétecteur à base de mercure tellure cadmium (CdHgTe ou CMT) tel que ceux présentés ci-dessus, et de l'absorption A du semiconducteur. Le photodétecteur que l'on considère ici est dimensionné pour optimiser la détection d'un faisceau lumineux polarisé transverse magnétique ayant une longueur d'onde de 5000 nm. Pour cela, les dimensions du photodétecteur sont choisies telles que l'équation (1) ou (2), et si besoin l'équation (3), soient satisfaites.

Pour un faisceau lumineux ayant une longueur d'onde de 5000 nm, l'absorption dans la couche de CdHgTe du photodétecteur est de l'ordre de 0,77 et le pouvoir réflecteur quasi nul. Contrairement aux photodétecteurs plasmons connus qui ont l'inconvénient de présenter une bande de détection très petite, le photodétecteur considéré ici présente une absorption qui diminue relativement peu, et un pouvoir réflecteur qui augmente relativement peu, lorsque la longueur d'onde du faisceau lumineux varie de 200 nm autour de la longueur d'onde de 5000 nm. La largeur à mi-hauteur du pic d'absorption est de l'ordre de 1700 nm, ce qui est de l'ordre du tiers de la longueur d'onde du faisceau incident.

La figure 7B représente deux courbes 55 et 57, respectivement du pouvoir réflecteur R d'un photodétecteur à base de CdHgTe et de l'absorption A du semiconducteur dans le cas d'un photodétecteur tel que présenté ici, en fonction de l'angle d'incidence du faisceau lumineux, le photodétecteur étant dimensionné pour absorber correctement le faisceau lumineux considéré. On note, sur les courbes 55 et 57, qu'une variation de l'angle d'incidence θ du faisceau lumineux de l'ordre de 50° ne fait quasiment pas varier l'absorption et le pouvoir réflecteur du photodétecteur.

Ainsi, les photodétecteurs des figures 3 à 6 permettent une détection large bande peu dépendante de l'angle d'incidence du faisceau lumineux. De plus, la formation d'un photodétecteur comprenant une couche semiconductrice mince permet la réalisation de pixels petits isolés entre eux correctement.

La couche semiconductrice 33, 39 pourra être prévue de façon à comprendre différentes régions permettant la collecte des porteurs photogénérés. Par exemple, on pourra prévoir de former localement une jonction PN verticale ou horizontale dans la couche semiconductrice 33, 39 ou encore une structure de type diode PIN (non représentée) verticale ou horizontale. Dans ce cas, les électrons photogénérés peuvent être stockés dans les régions dopées de type N de la couche semiconductrice et la détection se fait en transférant ces électrons à un circuit électronique, par exemple à l'aide d'un transistor de transfert.

Une fois les charges formées dans la portion semiconductrice 33 ou 39, plusieurs solutions sont possibles pour lire ces charges.

Une première solution consiste à polariser un ou plusieurs des plots métalliques 37, 43, 45 formés en surface de la couche semiconductrice à une première tension et à polariser la couche ou les plots inférieurs 31, 47 à une seconde tension. Le passage d'un courant résultant de cette polarisation est alors représentatif de l'éclairement du photodétecteur. Une variante consiste à polariser un ou plusieurs plots métalliques 43, 45, en surface de la couche semiconductrice 33, 39 à une première tension, et à polariser d'autres plots métalliques 43, 45 à une seconde tension. La détection est réalisée alors uniquement à partir de la face supérieure du photodétecteur.

Les figures 8A, 8B et 8C représentent trois variantes possibles de ce dernier cas, et plus précisément trois structures possibles des plots métalliques formés en surface d'une couche semiconductrice 33 et permettant la photodétection.

Dans l'exemple de la figure 8A, les plots métalliques formés en surface de la couche semiconductrice sont séparés en deux ensembles 61 et 63 ayant une forme de base de peigne, les peignes 61 et 63 étant interdigités. Chaque peigne 61 et 63 comporte une bande principale d'où s'étendent des bandes secondaires. Les peignes 61 et 63 sont prévus de telle façon que la largeur de la bande principale et des bandes secondaires réponde à l'équation (1) ou (2). Les bandes secondaires ont une période satisfaisant à l'équation (3).

Dans l'exemple de la figure 8B, les plots métalliques formés en surface de la couche semiconductrice 33 sont séparés en deux ensembles de doigts 65 et 67. Chaque ensemble de doigts est constitué d'une bande principale et de doigts secondaires qui s'étendent de la bande principale en ayant une forme sensiblement circulaire. Les bandes principales et les doigts secondaires répondent aux équations (1) ou (2) et (3).

Dans l'exemple de la figure 8C, des plots carrés 68, répartis sous forme d'une matrice en surface d'une couche semiconductrice 33, ne sont pas polarisés. Les dimensions et la période des plots 68 répondent aux équations (1) ou (2) et (3). Les plots 68 sont encadrés par deux électrodes 69A et 69B permettant la collecte.

La figure 9 illustre une variante de réalisation d'un photodétecteur. Le photodétecteur comprend une couche semiconductrice 33 sur laquelle sont formés des plots 73, 75 et 77 en métal ou en un matériau dont la permittivité est négative sur la bande de fréquence considérée. En dessous de la couche 33, au moins en regard des plots 73, 75 et 77, sont formées des portions métalliques 71. Les plots 73, 75 et 77 ont des largeurs différentes en surface de la couche semiconductrice 33. Comme la largeur des plots est liée à la longueur d'onde de la lumière photodétectée, les plots 73, 75 et 77 permettent la détection de lumières ayant des longueurs d'ondes différentes. Ainsi, le photodétecteur de la figure 9 permet la détection sélective de trois faisceaux lumineux de différentes longueurs d'onde.

En figure 9, une couche transparente 79 est formée sur le photodétecteur. Cette couche permet de protéger le photodétecteur. On notera que l'on pourra prévoir une telle couche sur chacune des variantes précédemment décrites. Cette couche pourra également avoir une forme adaptée à focaliser le faisceau lumineux incident vers chaque détecteur élémentaire (forme de lentille hémisphérique au-dessus de chaque plot 73, 75, 77 par exemple).

Les photodétecteurs précédemment décrits peuvent être utilisés par exemple pour former un capteur d'images couleur. Chaque photodétecteur élémentaire du capteur d'images comprend alors des plots 73, 75, 77 dimensionnés pour détecter une couleur donnée (rouge, vert, bleu). Ces photodétecteurs sont assemblés en une matrice de pixels couleur. A titre d'exemple de dimensions, le plus gros des photodétecteurs élémentaires, celui destiné à détecter les ondes lumineuses de couleur rouge ($\lambda \approx 600$ nm), comportant une couche de silicium ($n \approx 4$), comprendra un plot dont au moins une dimension est de l'ordre de 50 nm. Cette dimension est particulièrement petite par rapport aux dimensions courantes des photodétecteurs classiques à création directe de paires électrons/trous dans une couche semiconductrice.

De plus, "l'isolement" entre photodétecteurs élémentaires est simple à réaliser et occupe une surface minimale du fait qu'il suffit d'interrompre une couche semiconductrice extrêmement mince. On pourra, de la même façon, prévoir un capteur d'images multi-spectral autre qu'un capteur couleur.

Des modes de réalisation particuliers de la présente invention ont été décrits. Diverses variantes et modifications apparaîtront à l'homme de l'art. En particulier, bien que l'on ait décrit ici des photodétecteurs comprenant des plots supérieurs et une couche inférieure en un métal, on comprendra que la variante dans laquelle le photodétecteur comprend des plots supérieurs et une couche inférieure en un matériau ayant une permittivité négative à la fréquence considérée pourra être appliquée à chacune des variantes décrites ici.

## Revendications

1. Photodétecteur comprenant au moins une portion d'une couche semiconductrice (33, 39) formée directement sur au moins une portion d'une couche réfléchissante (31, 47) et destinée à être éclairée par un faisceau lumineux (35, 41), une pluralité de plots (37, 43, 45) étant formée sur la portion de la couche semiconductrice (33, 39), en regard de la portion de couche réfléchissante, les plots et la portion de la couche réfléchissante étant métalliques ou en un matériau à permittivité négative, la cavité optique formée entre ladite au moins une portion de la couche réfléchissante et lesdits plots ayant une épaisseur strictement inférieure au quart du rapport entre la longueur d'onde du faisceau lumineux et l'indice optique de la couche semiconductrice, de préférence de l'ordre du dixième de ce rapport, la couche semiconductrice (33) étant une couche d'épaisseur constante, dans lequel les plots, de forme carrée ou rectangulaire, sont formés périodiquement en surface de la portion de la couche semiconductrice (33, 39) Z et les plots étant placés périodiquement selon une période inférieure à 0,75 $\lambda$/n, $\lambda$ étant la longueur d'onde dudit faisceau lumineux, n étant l'indice optique de la couche semiconductrice.

2. Photodétecteur selon la revendication 1, dans lequel au moins une dimension des plots, dans un plan parallèle à la couche semiconductrice, est inférieure au rapport entre la longueur d'onde du faisceau lumineux et le double de l'indice optique de la couche semiconductrice.

3. Photodétecteur selon la revendication 1 ou 2, dans lequel la portion de la couche semiconductrice (33, 39) comporte une jonction PN ou PIN horizontale ou verticale.

4. Photodétecteur selon l'une quelconque des revendications 1 à 3, comprenant en outre une couche de matériau transparent (79) recouvrant le photodétecteur.

5. Photodétecteur selon l'une quelconque des revendications 1 à 4, comprenant en outre une couche d'accrochage et/ou à gradient d'indice (38) à l'interface entre la couche réfléchissante (31, 47) et la couche semiconductrice (33, 39).

6. Photodétecteur selon l'une quelconque des revendications 1 à 5, dans lequel les plots (37, 43, 45) et la couche réfléchissante (31, 47) sont en un métal adapté à créer, lorsque la couche semiconductrice (33, 39) est éclairée, un mode plasmon de cavité dans cette couche semiconductrice.

7. Photodétecteur selon la revendication 6, dans lequel la couche réfléchissante (31, 47) est en un métal dont l'épaisseur est supérieure à l'épaisseur de peau de ce métal, pour la longueur d'onde dudit faisceau lumineux.

8. Photodétecteur selon la revendication 7, dans lequel les plots métalliques (37, 43, 45) ont une épaisseur comprise entre une fois et trois fois l'épaisseur de peau du métal les constituant, pour la longueur d'onde dudit faisceau lumineux.

9. Photodétecteur selon l'une quelconque des revendications 1 à 5, dans lequel les plots (37, 43, 45) et la couche réfléchissante (31, 47) sont en un matériau ayant une permittivité négative, par exemple un cristal ionique, destiné à former, lorsque la couche semiconductrice (33, 39) est éclairée, des phonons à l'interface entre ledit matériau et la couche semiconductrice.

10. Capteur d'images multi-spectral comprenant plusieurs photodétecteurs élémentaires selon l'une quelconque des revendications 1 à 9, les dimensions des plots (37, 43, 45) de chaque photodétecteur élémentaire étant adaptées au spectre à détecter.

**Patentansprüche**

1. Ein Photodetektor, wobei der Photodetektor wenigstens einen Teil einer Halbleiterschicht (33, 39) aufweist, die direkt auf wenigstens einem Teil einer reflektierenden Schicht (31, 47) ausgebildet ist und die dafür vorgesehen ist von einem Lichtstrahl (35, 41) beleuchtet zu werden, eine Vielzahl von Plättchen (37, 43, 45), die auf dem Teil der Halbleiterschicht (33, 39) ausgebildet ist, gegenüber dem Teil der reflektierenden Schicht, die Plättchen und der Teil der reflektierenden Schicht sind metallisch oder sind aus einem Material hergestellt, das eine negative Dielektrizitätskonstante bzw. eine negative Permittivität aufweist, wobei die optische Kavität, die zwischen dem wenigstens einen Teil der reflektierenden Schicht und den Plättchen ausgebildet ist, eine Dicke aufweist die kleiner als ein Viertel des Verhältnisses zwischen der Wellenlänge des Lichtstrahls und des optischen Index der Halbleiterschicht ist, vorzugsweise im Bereich von einem Zehntel dieses Verhältnisses, wobei die Halbleiterschicht (33) eine Schicht mit einer konstanten Dicke ist und wobei die Plättchen, quadratisch oder rechteckig in ihrer Form, periodisch auf der Oberfläche des Teils der Halbleiterschicht (33, 39) ausgebildet sind und wobei die Plättchen periodisch angeordnet sind entsprechend einer Periode, die kleiner ist als 0.75 $\lambda$/n, wobei $\lambda$ die Wellenlänge des Lichtstrahls darstellt und n den optischen Index der Halbleiterschicht.

2. Der Photodetektor nach Anspruch 1, wobei wenigstens eine Dimension der Plättchen, in einer Ebene parallel zu der Halbleiterschicht, kleiner ist als das Verhältnis zwischen der Wellenlänge des Lichtstrahls und zweimal des optischen Index der Halbleiterschicht.

3. Der Photodetektor nach Anspruch 1 oder 2, wobei der Teil der Halbleiterschicht (33, 39) eine horizontale oder vertikale PN oder PIN Übergang aufweist.

4. Der Photodetektor nach einem der Ansprüche 1 bis 3, wobei der Photodetektor ferner eine Schicht aus einem transparenten Material (79) aufweist, die den Photodetektor abdeckt.

5. Der Photodetektor nach einem der Ansprüche 1 bis 4, wobei der Photodetektor ferner eine Bondingschicht aufweist und/oder eine Schicht mit einem Indexgradienten (38), an der Schnittstelle zwischen der reflektierenden Schicht (31, 47) und der Halbleiterschicht (33, 39).

6. Der Photodetektor nach einem der Ansprüche 1 bis 5, wobei die Plättchen (37, 43, 45) und die reflektierende Schicht (31, 47) aus einem Metall hergestellt sind, das geeignet ist, wenn die Halbleiterschicht (33, 39) beleuchtet wird, eine Kavität Plasmonmode in der Halbleiterschicht zu erzeugen.

7. Der Photodetektor nach Anspruch 6, wobei die reflektierende Schicht (31, 47) aus Metall hergestellt ist mit einer Dicke, die größer ist als die Eindringtiefe dieses Metalls, für die Wellenlänge des Lichtstrahls.

8. Der Photodetektor nach Anspruch 7, wobei die Metallplättchen (37, 43, 45) eine Dicke zwischen ein und dreimal der Eindringtiefe des Metalls das diese ausbildet aufweist, für die Wellenlänge des Lichtstrahls.

9. Der Photodetektor nach einem der Ansprüche 1 bis 5, wobei die Plättchen (37, 43, 45) und die reflektierende Schicht (31, 47) aus einem Material hergestellt sind, das eine negative Dielektrizitätskonstante bzw. eine negative Permittivität aufweist, beispielsweise einen ionischen Kristall, der dafür vorgesehen ist, wenn die Halbleiterschicht (33, 39) beleuchtet wird, Phononen an der Schnittstelle zwischen dem Material und der Halbleiterschicht auszubilden.

10. Ein multispektraler Bildsensor, wobei der Bildsensor eine Vielzahl von elementaren Photodetektoren gemäß einem der Ansprüche 1 bis 9 aufweist, wobei die Dimension der Plättchen (37, 43, 45) von jedem elementaren Photodetektor an das zu detektierende Spektrum angepasst ist.

**Claims**

1. A photodetector comprising at least a portion of a semiconductor layer (33, 39) formed directly on at least a portion of a reflective layer (31, 47) and intended to be illuminated by a light beam (35, 41), a plurality of pads (37, 43, 45) being formed on the portion of the semiconductor layer (33, 39), opposite to the reflective layer portion, the pads and the portion of the reflective layer being metallic or made of a material having a negative permittivity, the optical cavity formed between said at least a portion of the reflective layer and said pads having a thickness strictly smaller than one quarter of the ratio between the wavelength of the light beam and the optical index of the semiconductor layer, preferably in the order of one tenth of this ratio, the semiconductor layer (33) being a layer of constant thickness, wherein the pads, square or rectangular in shape, are formed periodically at the surface of the portion of the semiconductor layer (33, 39) and the pads are periodically arranged according to a period less than 0.75 $\lambda$/n, $\lambda$ being the wave length of said light beam, n being the optical index of the semiconductor layer.

2. The photodetector of claim 1, wherein at least one dimension of the pads, in a plane parallel to the semiconductor layer, is smaller than the ratio between the wavelength of the light beam and twice the optical index of the semiconductor layer.

3. The photodetector of claim 1 or 2, wherein the portion of the semiconductor layer (33, 39) comprises a horizontal or vertical PN or PIN junction.

4. The photodetector of any of claims 1 to 3, further comprising a layer of a transparent material (79) covering the photodetector.

5. The photodetector of any of claims 1 to 4, further comprising a bonding layer, and/or a layer with an index gradient (38), at the interface between the reflective layer (31, 47) and the semiconductor layer (33, 39).

6. The photodetector of any of claims 1 to 5, wherein the pads (37, 43, 45) and the reflective layer (31, 47) are made of a metal adapted to create, when the semiconductor layer (33, 39) is illuminated, a cavity plasmon mode in this semiconductor layer.

7. The photodetector of claim 6, wherein the reflective layer (31, 47) is made of a metal having a thickness greater than the skin depth of this metal, for the wavelength of said light beam.

8. The photodetector of claim 7, wherein the metal pads (37, 43, 45) have a thickness of between one and three times the skin depth of the metal forming them, for the wavelength of said light beam.

9. The photodetector of any of claims 1 to 5, wherein the pads (37, 43, 45) and the reflective layer (31, 47) are made of a material having a negative permittivity, for example an ionic crystal, intended to form, when the semiconductor layer (33, 39) is illuminated, phonons at the interface between said material and the semiconductor layer.

10. A multispectral image sensor comprising a plurality of elementary photodetectors according to any of claims 1 to 9, the dimensions of the pads (37, 43, 45) of each elementary photodetector being adapted to the spectrum to be detected.

Fig 1

Fig 2

Fig 3

Fig 4

Fig 5

Fig 6

Fig 7A

Fig 7B

Fig 8A

Fig 8B

Fig 8C

Fig 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006151807 A

- US 20080090318 A